Europäisches Patentamt

European Patent Office

Office européen des brevets

(19)

(11) Veröffentlichungsnummer: **0 259 596 B1**

(12) **EUROPÄISCHE PATENTSCHRIFT**

(45) Veröffentlichungstag der Patentschrift:
19.09.90

(51) Int. Cl.⁵: **G01N 24/14, H01J 49/38**

(21) Anmeldenummer: 87111091.2

(22) Anmeldetag: 31.07.87

(54) Verfahren zum Eliminieren unerwünschter geladener Teilchen aus der Messzelle eines ICR-Spektrometers.

(30) Priorität: 14.08.86 DE 3627605

(43) Veröffentlichungstag der Anmeldung:
16.03.88 Patentblatt 88/11

(45) Bekanntmachung des Hinweises auf die Patenterteilung:
19.09.90 Patentblatt 90/38

(84) Benannte Vertragsstaaten:
CH DE FR GB LI

(56) Entgegenhaltungen:
EP-A- 0 141 059
DE-A- 3 124 465

TRENDS IN ANALYTICAL CHEMISTRY, Band 5, Nr. 2,
Februar 1986, Seiten 44-49, Amsterdam, NL; G. BAYKUT
et al.: "Fourier transform Ion cyclotron resonance mass
spectrometry"
INTERNATIONAL JOURNAL OF MASS
SPECTROMETRY AND ION PROCESSES, Band 72,
Nr. 1/2, Oktober 1986, Selten 15-31, Amsterdam, NL;
S.K. HUANG et al.: "Mass-dependent-excitation of ions
In cubic traps used in FTMS"
MESSTECHNIK, Band 78, Nr. 6, Juni 1970,
Seiten 109-194; K.H. LEBERT
"Ionen-Cyclotronresonanz zur Untersuchung von
Ion-Molekül-Reaktionen"

(73) Patentinhaber: Spectrospin AG, Industriestrasse 26,
CH-8117 Zürich-Fällanden(CH)

(72) Erfinder: Allemann, Martin, Dr., Walderstrasse 7,
CH-8340 Hinwil(CH)

(74) Vertreter: Patentanwälte Kohler - Schwindling - Späth,
Hohentwielstrasse 41, D-7000 Stuttgart 1(DE)

**Beschreibung**

Die Erfindung betrifft ein Verfahren zum Eliminieren unerwünschter geladener Teilchen kleiner Masse aus der Meßzelle eines Ionen-Zyklotron-Resonanz-Spektrometers, die in einem homogenen Magnetfeld angeordnet ist und durch zur Richtung des Magnetfeldes senkrecht angeordnete Fangelektroden, die auf einem ein Fangfeld für die geladenen Teilchen erzeugenden Fangpotential gehalten werden, und zur Richtung des Magnetfeldes parallel angeordnete Sendeelektroden begrenzt ist, denen die zur Anregung der Zyklotronbewegung dienende HF-Spannung zugeführt wird, bei welchem Verfahren die zu eliminierenden geladenen Teilchen durch Modulation des Fangfeldes zu Fangschwingungen in Richtung des homogenen Magnetfeldes angeregt werden, so daß sie unter Überwindung der Fangpotentiale die Fangelektroden erreichen und über die Fangelektroden abgeführt werden.

Das Eliminieren von geladenen Teilchen kleiner Masse aus den Meßzellen von Ionen-Zyklotron-Resonanz-oder kurz ICR-Spektrometern ist für eine Anzahl von Experimenten von Bedeutung. So ist das Eliminieren von He$^+$-Ionen in hohem Maße für Experimente mit Gaschromatographie von Bedeutung, um den Dynamikbereich des Instrumentes zu verbessern. Eine große Anzahl von He$^+$-Ionen, die vom Trägergas stammen, führen zu erheblichen Raumladungs-Effekten, welche die Wirksamkeit der Ionenfalle beeinträchtigen, wenn keine Maßnahmen getroffen werden, um die He$^+$-Ionen vor der Signaldetektion zu entfernen. Ähnlich können beim Arbeiten mit negativen Ionen gefangene Elektronen die Experimente in unerwünschter Weise beeinflussen. Daher ist die Möglichkeit, solche Teilchen kleiner Masse zu entfernen, eine wichtige Eigenschaft von ICR-Spektrometern hoher Leistung.

Das Eliminieren dieser Teilchen kann jedoch nicht leicht mit der üblichen Technik der Doppelresonanz erreicht werden, weil die Zyklotron-Resonanzfrequenzen solch leichter Teilchen sehr hoch sind. Bei einer Stärke des homogenen Magnetfeldes von 4,7 Tesla beträgt die Zyklotron-Resonanzfrequenz von Elektronen etwa 140 GHz. Eine derart hohe Frequenz liegt weit außerhalb des Frequenzbereiches der elektronischen Einrichtungen üblicher ICR-Spektrometer. Daher ist es z.B. aus "messtechnik" 78 (6, 1970) 109 bis 195 bekannt, zum Eliminieren solch leichter Teilchen die harmonischen Schwingungen auszunutzen, welche diese Teilchen längs der magnetischen Feldlinie ausführen, nämlich die sogenannte Fangschwingung. Auch aus einem Aufsatz von McIver et al in "Lecture notes in chemistry", (1982), Seiten 164 bis 182, ist es bekannt, an die Fangelektroden einen Oszillator anzuschließen, mit dem es möglich ist, Elektronen zu Fangschwingungen in Richtung des Magnetfeldes anzuregen, bis sie die Fangelektroden berühren, und dadurch zu eliminieren. Dieses Verfahren hat jedoch den Nachteil, daß es den Einsatz eines zusätzlichen, abstimmbaren Senders erfordert, da die Resonanzfrequenz der Fangschwingungen nicht nur von dem Ladungs/Massen-Verhältnis der zu eliminierenden Teilchen, sondern auch von dem an die Fangelektroden angelegten Potential abhängen.

Der Erfindung liegt die Aufgabe zugrunde, ein Verfahren der eingangs genannten Art anzugeben, zu dessen Durchführung es keines zusätzlichen, elektronisch abstimmbaren Oszillators bedarf.

Diese Aufgabe wird nach der Erfindung dadurch gelöst, daß die Modulation des Fangfeldes durch Zuführen einer HF-Spannung zu den Sendeelektroden erfolgt.

Es hat sich gezeigt, daß wegen der unvermeidlichen Inhomogenitäten des HF-Feldes, das durch Anlegen einer HF-Spannung an die Sendeelektroden erzeugt wird, dieses Feld auch eine Komponente in Richtung des homogenen Magnetfeldes und damit auch des Fangfeldes hat, die dazu ausreicht, geladene Teilchen kleiner Masse in Richtung des homogenen Magnetfeldes zu Fangschwingungen anzuregen und dadurch die Energie dieser geladenen Teilchen so stark zu erhöhen, daß sie die Fangpotentiale überwinden können. Dabei ist die Anwendung einer HF-Spannung besonders wirksam, deren Frequenz doppelt so groß ist wie die Resonanzfrequenz der Fangschwingungen der zu eliminierenden geladenen Teilchen.

Der Vorteil des erfindungsgemäßen Verfahrens besteht darin, daß zu seiner Durchführung keine zusätzlichen Einrichtungen benötigt werden, sondern daß von dem HF-Sender Gebrauch gemacht werden kann, der auch sonst zur Eliminierung und Anregung von geladenen Teilchen mit der Zyklotron-Resonanzfrequenz bei den üblichen Doppel-Resonanz-Experimenten benötigt wird.

Dem erfindungsgemäßen Verfahren liegt die Theorie zugrunde, daß sich die geladenen Teilchen in ICR-Meßzellen unter dem Einfluß inhomogener elektrischer Felder und eines homogenen Magnetfeldes bewegen. Die Bewegung der geladenen Teilchen ist daher eine Überlagerung von Zyklotron- und Drift-Bewegungen, die in einer Ebene senkrecht zum Magnetfeld verlaufen, und einer Fangschwingung mit der Frequenz $\omega$ längs des Magnetfeldes. Die Frequenz der Fangschwingung eines geladenen Teilchens in einer zylindrischen ICR-Meßzelle ist gegeben durch

$$\omega_T = \left( \frac{q V_T S_{T2}^o 4}{m R^2} \right)^{1/2} \cdot \; = \left( \frac{4 q V_T S_{T2}^o}{m R^2} \right)^{1/2} \quad (1)$$

In Gl. (1) bedeuten m die Masse des Teilchens, q dessen Ladung und $V_T$ die Potentialdifferenz zwischen den Fangelektroden und Seitenelektroden. R ist der Radius der Meßzelle und $S^\circ_{T2}$ ist ein Geometrie-Faktor.

Es ist bekannt, daß die Fangschwingung angeregt werden kann, indem an eine der Fangelektroden eine HF-Spannung mit der aus Gl. (1) hervorgehenden Frequenz angelegt wird. Die Zyklotronbewegung der geladenen Teilchen, die gewöhnlich zum Bestimmen des Massen/Ladungs-Verhältnisses benutzt wird, wird gewöhnlich durch einen HF-Impuls angeregt, der einer der Sendeelektroden zugeführt wird, und durch einen um 180° phasenverschobenen Impuls gleiche Amplitude, welcher der gegenüberliegenden Sendeelektrode zugeführt wird. Das dadurch erzeugte HF-Feld hat sowohl bei zylindrischen als auch bei kubischen Meßzellen eine Komponente in Richtung der mit der Richtung des homogenen Magnetfeldes zusammenfallenden Z-Achse. In einer zylindrischen Meßzelle ist die Kraft, die von dieser Komponente auf ein Teilchen mit der Ladung q ausgeübt wird, gegeben durch

$$F_z = \frac{4qV_E \, S^1_{E3}}{R^3} XZ \; ; \; V_E = V_E^{\,0} \cos \omega t \qquad (2)$$

In diesen Gleichungen ist $V_E$ die Amplitude der HF-Spannung, $S^1_{E3}$ ein Geometrie-Faktor und R der Radius der Meßzelle.

Es läßt sich durch einfache Umrechnung zeigen, wie dieses elektrische Feld zum Anregen der Fangschwingung von geladenen Teilchen und Elektronen benutzt werden kann. Dazu sei angenommen, daß das Einstrahlen des HF-Impulses eine geringe Störung des stationären Zustandes der geladenen Teilchen in der ICR-Meßzelle verursacht. Weiterhin soll die Zeit, während welcher die HF-Spannung an die Sendeelektroden der Meßzelle angelegt wird, sehr viel größer sein als die Periode der Fangschwingung. Der Energieaustausch ist dann gegeben durch

$$dE/dt = \vec{F} \vec{v} \; ; \; \triangle E = \int_0^T \vec{F} \vec{v} \, dt. \qquad (3)$$

In diesen Gleichungen ist F die Kraft, welche auf das Teilchen ausgeübt wird, und v die Geschwindigkeit.

Es sei weiter angenommen, daß die Bewegungen in der Z-Richtung und in der X, Y-Ebene nicht gekoppelt sind, so daß sich die Berechnung auf die Bewegung in der Z-Richtung beschränken kann. In folgenden wird der mittlere Energiezuwachs berechnet, den die Teilchen unter dem Einfluß eines HF-Feldes erfahren. Gl. (2) und (3) können kombiniert werden zu

$$\triangle E = \frac{4qV_E^2 \, S^1_{E3} \cdot X \, T}{R^3} \int_0^T \cos\omega t \; Z\dot{Z} dt \; ; \quad C = \frac{4qV_E^2 \, S^1_{E3} \cdot X}{R^3} \qquad (4)$$

Die Fangschwingung wird angenähert beschrieben durch

$$Z(t) = Z_0 \cos(\omega_T t + \phi) . \qquad (5)$$

Die Kombination der Gl. (4) und (5) führt nach einigen trigonometrischen Umrechnungen zu

$$\triangle E = -\frac{1}{2} C \, Z_0^2 \, \omega_T \int_0^T \cos\omega t \, \sin(2\omega_T t + 2\phi) dt. $$

Eine trigonometrische Umwandlung und die Vernachlässigung des periodischen Gliedes führt zu

$$\triangle E = \frac{1}{4} c Z_0^2 \omega_T \cdot \frac{\cos\{(2\omega_T - \omega)t + 2\not{\text{p}}\}/^{\cdot\cdot}}{2\omega_T - \omega}\Bigg/ \qquad (7)$$

Ein nennenswerter mittlerer Energiegewinn kann nur stattfinden, wenn $\omega = 2 \cdot \omega_T$ unter dieser Bedingung erhält man schließlich

$$\triangle E = -\frac{1}{4} c Z_0^2 \omega_T \sin 2\not{\text{p}} \, . \qquad (8)$$

Wenn geladene Teilchen aus der Meßzelle in Z-Richtung entfernt werden sollen, muß der Energiegewinn $\triangle E$ wenigstens so groß sein wie die Höhe der Fangpotentiale $qV_T$.

Diese einfache Berechnung sagt voraus, daß der Energiezuwachs in Z-Richtung am stärksten ist, wenn die Frequenz der eingestrahlten Energie doppelt so groß ist wie die Frequenz der Fangschwingung des Teilchens, das eliminiert werden soll.

Die Erfindung wird im folgenden anhand einiger Versuche und in der Zeichnung dargestellter, zugehöriger Diagramme näher beschrieben und erläutert. Die der folgenden Beschreibung und der Zeichnung zu entnehmenden Merkmale können bei weiteren Ausführungsformen des erfindungsgemäßen Verfahrens einzeln für sich oder zu mehreren in beliebiger Kombination Anwendung finden. Es zeigen

Fig. 1 die schematische Darstellung der Meßzelle eines Ionen-Zyklotron-Resonanz-Spektrometers,
Fig. 2 ein Diagramm der Intensität von He⁺-Ionen als Funktion der eingestrahlten Resonanzfrequenz und
Fig. 3 ICR-Spektren mit und ohne erfolgter Eliminierung von Elektronen.

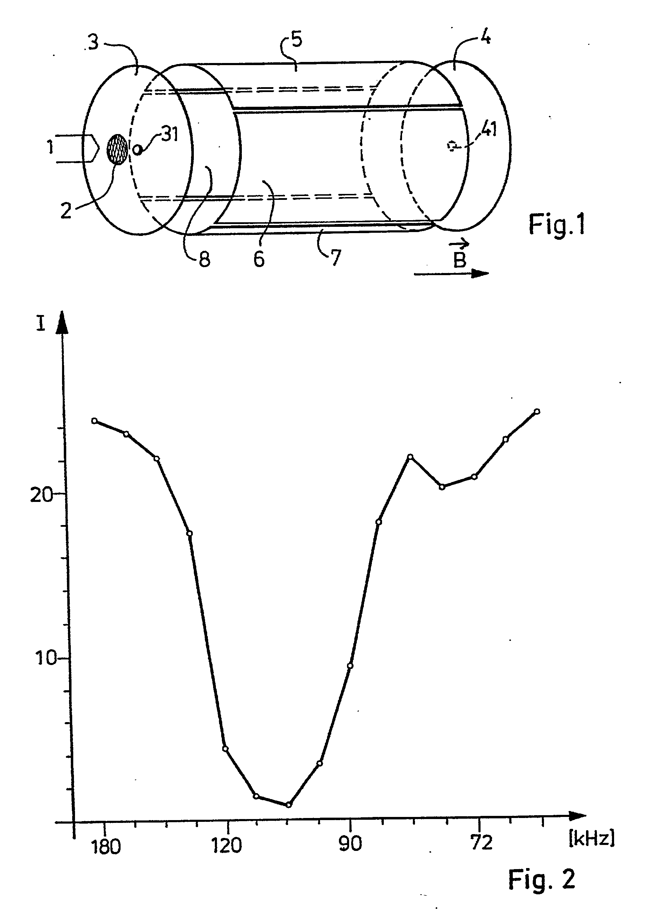

Die im folgenden beschriebenen Versuche wurden mit einem ICR-Spektrometer der Firma Spectrospin AG vom Typ CMS 47 ausgeführt, das mit Einrichtungen zur Fouriertransformation versehen war. Das Spektrometer hatte einen supraleitenden Magneten mit einem Umgebungstemperatur ausgesetzten Meßraum von 150 mm Durchmesser, in dem eine Feldstärke von 4,7 Tesla herrschte. In dem Meßraum befand sich eine Meßzelle mit dem in Fig. 1 dargestellten Aufbau. In Richtung des von dem supraleitenden Magneten erzeugten Magnetfeldes $\vec{B}$ sind im Abstand voneinander zwei senkrecht zur Richtung des Magnetfeldes stehende Fangelektroden 3, 4 angeordnet, die kleine zentrale Löcher 31, 41 zum Durchschnitt eines Elektronenstrahles aufweisen, der mittels einer Glühkathode 1 und eines Beschleunigungsgitters 2 erzeugbar ist. Der von den beiden Fangelektroden begrenzte Raum von vier weiteren Elektroden 5 bis 8 umgeben, die jeweils einen Sektor eines Kreiszylinders bilden. Das eine Paar der einander gegenüberliegenden Elektroden bildet Sendeelektroden 6, 8, an die in üblicher Weise ein HF-Sender angeschlossen war, während das andere Paar Empfangselektroden 5, 7 bildet, an die in üblicher Weise der Empfänger angeschlossen war. An die Fangelektroden 3, 4 konnten in ebenfalls üblicher Weise Fangpotenziale angelegt werden. Das Spektrometer hatte außerdem einen Zusatz zur Messung kleiner Massen und war daher in der Lage, Ladungs/ Massen-Verhältnisse von 2 bis 3500 zu messen. Daher konnte man mit diesem Instrument He⁺-Ionen messen und zweifelsfrei feststellen, ob He⁺-Ionen durch Anregung ihrer Fangschwingung eliminiert werden konnten oder nicht.

Die Versuche zeigten eindeutig, daß die Fangschwingung geladener Teilchen durch Zuführen von HF-Impulsen zu den Sendeelektroden 6, 8 der ICR-Meßzelle angeregt werden kann.

Wie Fig. 2 zeigt, nimmt die Intensität der He⁺-Ionen als Funktion der eingestrahlten Frequenz ein Minimum bei 106 kHz an, wenn die meisten He⁺-Ionen aus der Meßzelle eliminiert sind. Es wurden für diesen Versuch HF-Impulse mit einer Amplitude von 12 V und einer Dauer von 100 μs benutzt. Die Frequenz von 106 kHz, bei der das Minimum der He⁺-Intensität vorliegt, entspricht etwa der doppelten Resonanzfrequenz der Fangschwingung und ist in guter Übereinstimmung mit dem theoretischen Wert, für den 116 kHz ermittelt wurde.

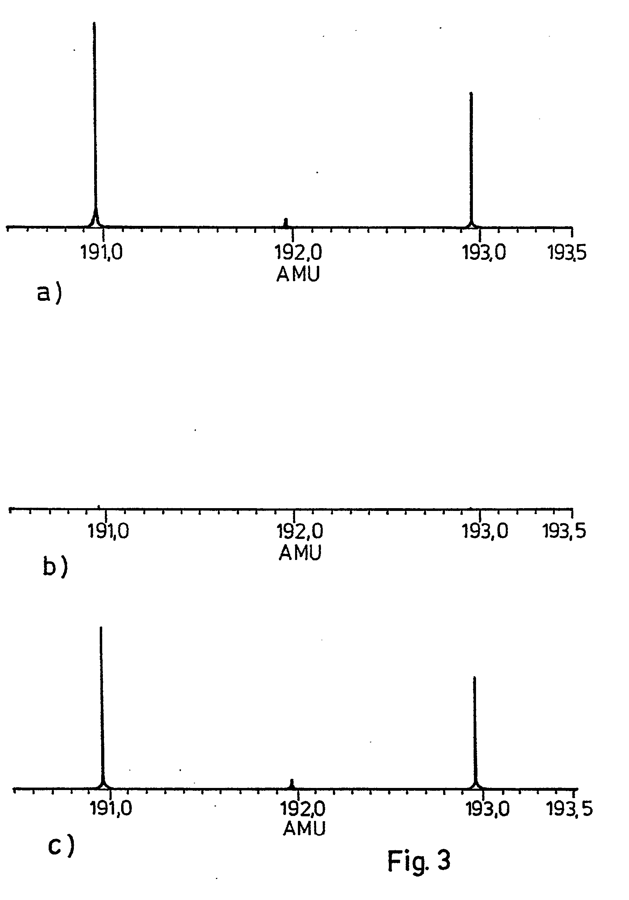

Fig. 3 veranschaulicht die Nützlichkeit des erfindungsgemäßen Verfahrens für das Eliminieren von Elektronen. Zu diesem Zweck wurden die ICR-Spektren von negativ ionisiertem 1,2-Dichlor-4-nitrobenzol gemessen. Zur Ionisierung des 1,2-Dichlor-4-nitrobenzols diente ein Elektronenstrahl-Impuls. Nach diesem Elektronenstrahl-Impuls bedarf es einer gewissen Reaktionszeit, bis sich eine ausreichende Anzahl negativer Ionen gebildet hat und demgemäß Ionen feststellbar sind. Es ist anzunehmen, daß in der Meßzelle gefangene Elektronen von den neutralen Molekülen der Probe während der Reaktionszeit eingefangen werden und dadurch negative Ionen bilden. Wenn ein HF-Impuls mit einer Frequenz, die doppelt so groß ist wie die berechnete Resonanzfrequenz der Fangschwingung von Elektronen, vor der Reaktionszeit zugeführt wird, verschwindet das Signal fast vollständig, wie es Fig. 2b zeigt. Dieses Verschwinden des Signals ist ein Zeichen dafür, daß die Elektronen aus der Zelle eliminiert wurden, bevor sie mit den Molekülen der Probe reagieren konnten. Wenn der gleiche HF-Impuls nach der Reaktionszeit eingestrahlt wird, hat das Signal fast die gleiche Intensität als wenn überhaupt keine Einstrahlung stattgefunden hätte, weil die bereits gebildeten negativen Ionen von dem HF-Impuls nicht mehr beeinflußt werden (Fig. 2c).

Die für das Eliminieren der leichten geladenen Teilchen benötigte Zeit und die Intensität des eingestrahlten Signales sind nur wenig geringer als bei Doppelresonanz-Experimenten, obwohl sehr viel weniger Energie erforderlich sein sollte, um die geladenen Teilchen über das Fangpotential anzuheben (einige wenige eV), als benötigt wird, um sie zur Kollision mit den Sendeelektroden zu bringen (einige keV). Es sind jedoch die Komponenten des HF-Feldes in der Nähe der Z-Achse, wo die meisten geladenen Teilchen erzeugt werden, nur schwach und es kann daher der Anregungsprozess für die Fangschwingungen nicht so wirksam sein als wie für die Zyklotron-Schwingungen. Auf der Z-Achse selbst ist die Z-Komponente des HF-Feldes Null, so daß geladene Teilchen, die sich sehr nahe an der Z-Achse befinden, mit dem hier beschriebenen Verfahren nicht eliminiert werden können.

Das erfindungsgemäße Verfahren macht von den vorhandenen elektronischen Einrichtungen eines ICR-Spektrometers Gebrauch und benötigt keinen speziellen Oszillator, der mit einer der Fangelektroden verbunden ist. Die Erzeugung der HF-Signale steht bei dem oben erwähnten Massenspektrometer vom Typ CMS 47 vollständig unter der Steuerung eines Rechners, so daß die Änderung der Frequenz des HF-Signales zum Anregen von Fangschwingungen, die zum Eliminieren verschiedener Teilchen geringer Masse, wie Elektronen, He+-Ionen usw. führen, automatisch erfolgen kann. Das Auffinden der optimalen Frequenz für die Teilcheneliminierung über die Fangschwingung ist daher stark vereinfacht, zumal auch die Resonanz sehr breit ist und die Spektrometer-Elektronik in der Lage ist, den für die Teilchen-Eliminierung interessierenden Frequenzbereich zu überstreichen.

Ein allgemeines Problem der Eliminierung von geladenen Teilchen mittels des erfindungsgemäßen Verfahrens besteht natürlich darin, daß Ionen größerer Masse gestört oder sogar ebenfalls eliminiert werden, wenn das eingestrahlte HF-Signal mit der Zyklotron-Frequenz dieser Ionen übereinstimmt. Wenn Elektronen aus der hier verwendeten zylindrischen Meßzelle eliminiert werden sollen, muß zur Anregung der Fangschwingung von Elektronen eine Frequenz von etwa 6MHz eingestrahlt werden. Diese Frequenz entspricht der Zyklotron-Frequenz von Ionen mit einem Masse/Ladungs-Verhältnis von 12 bei einer Feldstärke von 4,7 T. Diese Masse ist im allgemeinen bei ICR-Experimenten von untergeordneter Bedeutung. Bei einer Kopplung von Gaschromatographie und Massenspektrometrie ist, wie bereits erwähnt, eine Eliminierung von He+-Ionen von Interesse. Die Frequenz, die zum Eliminieren von He+-Ionen mittels der Fangschwingung einzustrahlen ist, beträgt etwa 20kHz. Dieser Frequenz entspricht die Zyklotron-Bewegung von Ionen mit 3500 amu. Wenn solche Ionen durch gleichzeitiges Anregen ihrer Zyklotron-Frequenz eliminiert werden, ergeben sich hieraus normalerweise keine Probleme, weil Ionen solch hoher Masse ohnehin nicht mittels der Gaschromatographie untersucht werden können.

Es versteht sich, daß die vorstehend behandelten Beispiele nur der Erläuterung der Erfindung dienen und die Einzelheiten des erfindungsgemäßen Verfahrens, insbesondere die anzuwendenden Frequenzen, Signalamplituden und auch die Dauer der Signaleinstrahlung sowohl von den Parametern der verwendeten Geräte als auch von den zu untersuchenden Substanzen und der Menge der dabei auftretenden, zu eliminierenden geladenen Teilchen abhängen.

**Patentansprüche**

1. Verfahren zum Eliminieren unerwünschter geladener Teilchen kleiner Masse aus der Meßzelle eines Ionen-Zyklotron-Resonanz-Spektrometers, die in einem homogenen Magnetfeld $\vec{B}$ angeordnet ist und durch zur Richtung des Magnetfeldes $\vec{B}$ senkrecht angeordneten Fangelektroden (3, 4), die auf einem ein Fangfeld für die geladenen Teilchen erzeugenden Fangpotential gehalten werden, und zur Richtung des Magnetfeldes $\vec{B}$ parallel angeordnete Sendeelektroden (6, 8) begrenzt ist, denen die zur Anregung der Zyklotron-Bewegung dienende HF-Spannung zugeführt wird, bei welchem Verfahren die zu eliminierenden geladenen Teilchen durch Modulation des Fangfeldes zu Fangschwingungen in Richtung des homogenen Magnetfeldes $\vec{B}$ so stark angeregt werden, daß sie die Fangelektroden (3, 4) erreichen und dadurch eliminiert werden,
dadurch gekennzeichnet,
daß die Modulation des Fangfeldes durch Zuführen einer HF-Spannung zu den Sendeelektroden (6, 8) erfolgt.

2. Verfahren nach Anspruch 1, dadurch gekennzeichnet, daß den Sendeelektroden (6, 8) eine HF-Spannung zugeführt wird, deren Frequenz doppelt so groß ist wie die Resonanzfrequenz der Fangschwingung der zu eliminierenden geladenen Teilchen.

**Claims**

1. Method of removing unwanted charged particles of a small mass from the measuring cell of an ion cyclotron resonance spectrometer, which is positioned in a homogenous magnetic field $\vec{B}$ and which is bounded by means of collecting electrodes (3, 4) which are disposed perpendicular to the direction of the magnetic field $\vec{B}$ and which are maintained at a collecting potential producing a collector region for the charged particles, and transmitting electrodes which are disposed parallel to the magnetic field $\vec{B}$ and to which there is supplied a high frequency voltage serving to activate the cyclotron movement, in which method the charged particles to be eliminated are energized to such an extent by modulating the collector region to form collecting oscillations in the direction of the homogenous magnetic field $\vec{B}$ that they reach the collecting electrodes, (3, 4) and are thereby eliminated, characterized in that the collector region is modulated by supplying a high frequency voltage to the transmitting electrodes (6, 8).

2. Method according to claim 1, characterized in that a high frequency voltage is supplied to the transmitting electrodes (6, 8), the frequency of Which is twice as great as the resonance frequency of the collecting oscillation of the charged particles to be eliminated.

**Revendications**

1. Procédé d'élimination de particules de faible masse chargées indésirables dans la cellule de mesure d'un spectromètre à résonance, pourvu d'un cyclotron d'ions, qui est agencé dans un champ magnétique homogène $\vec{B}$ et qui est délimité par des électrodes réceptrices (3, 4), agencées perpendiculairement à la direction du champ magnétique $\vec{B}$ et maintenues à un potentiel de captage produisant un champ de captage pour les particules chargées, et par des électrodes émettrices (6, 8) agencées parallèlement à la direction du champ magnétique $\vec{B}$ et alimentées par la tension HF servant à l'excitation du mouvement de cyclotron, dans ledit procédé les particules chargées à éliminer étant tellement fortement excitées par une modulation du champ de captage en des oscillations de captage dans la direction du champ magnétique homogène $\vec{B}$ qu'elles atteignent les électrodes réceptrices (3, 4) et sont éliminées de ce fait, caractérisé en ce que la modulation du champ de captage résulte de l'alimentation d'une tension HF aux électrodes émettrices (6, 9).

2. Procédé suivant la revendication 1, caractérisé en ce qu'aux électrodes émettrices (6, 8) est alimentée une tension HF dont la fréquence est le double de la fréquence de résonance de l'oscillation de captage des particules chargées à éliminer.

Fig.1

Fig. 2

a)

b)

c)

Fig. 3